# EUROPEAN PATENT APPLICATION

(11) **EP 4 317 523 A1**
(43) Date of publication of application: **07.02.2024**
(21) Application number: 23736964.0
(22) Date of filing: 01.01.2023
(51) Int. Cl.: C23C 14/24, C23C 14/02, C23C 14/26, C23C 14/56, B05C 9/06, B65H 18/10

(54) **METHOD, DEVICE AND SYSTEM FOR PREPARING COMPOSITE METAL FOIL**

(30) Priority: 04.01.2022 CN 202210002410
(71) Applicant: Chongqing Jimat New Material Technology Co., Ltd., Qijiang District, Chongqing 401421 (CN)
(72) Inventor: ZANG, Shiwei, Chongqing 401421 (CN)
(74) Representative: Bayramoglu et al.
(86) International application number: PCT/CN2023/070001
(87) International publication number: WO 2023/131099

(57) **Abstract**

The present disclosure provides a method, device, and system for manufacturing a composite metal foil. The device includes: a first-time double-sided coating module and a second-time double-sided coating module that are arranged at an interval, where the first-time double-sided coating module includes: a first vapor deposition column and a second vapor deposition column that are arranged oppositely, and an unwinding roller, a first evaporation source, a first set of over rollers, a second evaporation source, and a second set of over rollers that are arranged sequentially from bottom to top on opposite surfaces of the first vapor deposition column and the second vapor deposition column; and the second-time double-sided coating module includes: a third vapor deposition column, and a first set of cooling rollers, a third evaporation source, a second set of cooling rollers, a fourth evaporation source, and a winding roller that are arranged sequentially from top to bottom on the third vapor deposition column. The sequential arrangement of the two evaporation sources and corresponding rollers from bottom to top on the opposite surfaces of the first vapor deposition column and the second vapor deposition column allows first-time double-sided coating, and the sequential arrangement of the two evaporation sources and corresponding rollers from top to bottom on the third vapor deposition column allows second-time double-sided coating, which can improve the site utilization and the film production efficiency.

## Description

### TECHNICAL FIELD

The present disclosure relates to the technical field of vapor deposition for films, and in particular relates to a method, device, and system for manufacturing a composite metal foil.

### BACKGROUND

Vapor deposition refers to a process where a material to be deposited is placed in a high temperature-resistant container such as a crucible and heated, such that the material to be deposited is vaporized and deposited on a passing film.

The Chinese Patent CN106086808A "Winding Vacuum Coating Machine and Coating Process" discloses a winding vacuum coating machine, including a vacuumed box body, where upper parts at left and right ends in the box body are provided with a substrate unwinding roller and a substrate winding roller, respectively; a plurality of cooling rollers are provided below a position between the substrate unwinding roller and the substrate winding roller, and an evaporation source is provided below each of the plurality of cooling rollers; and the plurality of evaporation sources are arranged horizontally.

When implementing the present disclosure, the inventors have found that there are at least the following problems in the prior art:
The existing vapor deposition machines have a tiled design, a large floor space, and low space utilization. In addition, in the existing vapor deposition machines, after a roll of coating is completed, the vacuum cavity needs to be opened to continue the unwinding, and it is impossible to allow a plurality of rolls of coating at one time, resulting in low production efficiency.

### SUMMARY

In view of this, an objective of an embodiment of the present disclosure is to provide a method, device, and system for manufacturing a composite metal foil, which can solve the problems of low space utilization and low production efficiency in the prior art.

In a first aspect, an embodiment of the present disclosure provides a device for manufacturing a composite metal foil, including: a first-time double-sided coating module and a second-time double-sided coating module that are arranged at an interval,
where the first-time double-sided coating module includes: a first vapor deposition column and a second vapor deposition column that are arranged oppositely, and an unwinding roller, a first evaporation source, a first set of over rollers, a second evaporation source, and a second set of over rollers that are arranged sequentially from bottom to top on opposite surfaces of the first vapor deposition column and the second vapor deposition column; and
the second-time double-sided coating module includes: a third vapor deposition column, and a first set of cooling rollers, a third evaporation source, a second set of cooling rollers, a fourth evaporation source, and a winding roller that are arranged sequentially from top to bottom on the third vapor deposition column.

In some possible embodiments, the first set of over rollers include a first over roller and a second over roller that are arranged at two upper sides of the first evaporation source, respectively; the second set of over rollers include a third over roller and a fourth over roller that are arranged at two upper sides of the second evaporation source, respectively; the first set of cooling rollers include a first cooling roller and a second cooling roller, and the second set of cooling rollers include a third cooling roller and a fourth cooling roller; the first set of cooling rollers, the third evaporation source, the second set of cooling rollers, the fourth evaporation source, and the winding roller are arranged at a same side of the third vapor deposition column; the first evaporation source is configured to apply a first coating to a first surface of a film to be coated; the second evaporation source is configured to apply a first coating to a second surface of the film to be coated; the third evaporation source is configured to apply a second coating to the second surface of the film to be coated; and the fourth evaporation source is configured to apply a second coating to the first surface of the film to be coated.

In some possible embodiments, a vertical downward tangent line of the first over roller at a left side coincides with a vertical downward tangent line of the unwinding roller at a left side, and a vertical downward tangent line of the second over roller at a right side coincides with a vertical downward tangent line of the unwinding roller at a right side.

In some possible embodiments, a plane in which a center line between the first over roller and the second over roller is located is a symmetrical plane between the first evaporation source and the second evaporation source; or, a tangent plane of a top of the first over roller or a tangent plane of a bottom of the second over roller is a symmetrical plane between the first evaporation source and the second evaporation source.

In some possible embodiments, at least one of the first over roller, the second over roller, the third over roller, and the fourth over roller is a cooling roller.

In some possible embodiments, the first set of over rollers, the second set of over rollers, the first set of cooling rollers, the second set of cooling rollers, the unwinding roller, and the winding roller are parallel to each other; and the first vapor deposition column, the second vapor deposition column, and the third vapor deposition column are arranged in a vertical direction.

In some possible embodiments, a vertical arrangement height of the first over roller is lower than a vertical arrangement height of the second over roller, and the highest point of the top of the first over roller is on the same horizontal line as the lowest point of the bottom of the second over roller.

In some possible embodiments, the device for manufacturing a composite metal foil further includes: a steering module, where the steering module includes a fourth vapor deposition column, and a first steering roller and a second steering roller that are arranged sequentially from top to bottom on the fourth vapor deposition column; and the first vapor deposition column, the third vapor deposition column, and the fourth vapor deposition column are arranged at an interval on a same straight line.

In a second aspect, an embodiment of the present disclosure provides a system for manufacturing a composite metal foil, including:
the device for manufacturing a composite metal foil described in the first aspect;
a visual inspection system, where the visual inspection system is arranged on the first vapor deposition column, the second vapor deposition column, the third vapor deposition column, or the fourth vapor deposition column or on an inner wall of a vacuum cavity, and configured to detect a pore defect on a film to be coated; and when acquired pore defect data meets preset conditions, a signal to stop coating is output; and
the vacuum cavity, where the device for manufacturing a composite metal foil described in the first aspect is arranged inside the vacuum cavity.

In a third aspect, an embodiment of the present disclosure provides a method for manufacturing a composite metal foil based on the device for manufacturing a composite metal foil described in the first aspect, including the following steps:
releasing a film by the unwinding roller, and guiding the film to pass through the first over roller, an upper part of the first evaporation source, and the second over roller, such that a first coating is applied to a surface A of the film;
guiding the film to pass through the fourth over roller and an upper part of the second evaporation source sequentially and reach the third over roller, such that a first coating is applied to a surface B of the film;
guiding the film to pass through the second cooling roller and an upper part of the third evaporation source sequentially and reach the first cooling roller, such that a second coating is applied to the surface B of the film;
guiding the film to pass through the first steering roller and reach the second steering roller;
guiding the film to pass through the third cooling roller and an upper part of the fourth evaporation source sequentially and reach the fourth cooling roller, such that a second coating is applied to the surface A of the film; and
guiding the film to reach the winding roller, such that double-sided continuous coating of the film is completed to obtain the composite metal foil.

The above technical solutions have following beneficial effects:
The sequential arrangement of the two evaporation sources and corresponding rollers from bottom to top on the opposite surfaces of the first vapor deposition column and the second vapor deposition column allows first-time double-sided coating, and the sequential arrangement of the two evaporation sources and corresponding rollers from top to bottom on the third vapor deposition column allows second-time double-sided coating, which can reduce a floor space of the vapor deposition device and improve the vacuum space utilization and the film production efficiency.

### BRIEF DESCRIPTION OF THE DRAWINGS

To describe the technical solutions in the embodiments of the present disclosure or in the prior art clearly, the accompanying drawings required for describing the embodiments or the prior art will be briefly described below. Apparently, the accompanying drawings in the following description only show some embodiments of the present disclosure, and a person of ordinary skill in the art may still derive other accompanying drawings from these accompanying drawings without creative efforts.
FIG. 1 is a three-dimensional (3D) schematic view of a first device for manufacturing a composite metal foil in Embodiment 1 of the present disclosure;
FIG. 2 is a side schematic view of the first device for manufacturing a composite metal foil in Embodiment 1 of the present disclosure;
FIG. 3 is a front schematic view of a first-time double-sided coating module of the first device in Embodiment 1 of the present disclosure;
FIG. 4 is a front schematic view of a second-time double-sided coating module of the first device in Embodiment 1 of the present disclosure;
FIG. 5 is a 3D schematic view of a second device for manufacturing a composite metal foil in Embodiment 1 of the present disclosure;
FIG. 6 is a side schematic view of the second device for manufacturing a composite metal foil in Embodiment 2 of the present disclosure;
FIG. 7 is a side schematic view of a third device for manufacturing a composite metal foil in Embodiment 2 of the present disclosure;
FIG. 8 is a functional block diagram of a visual inspection system in an embodiment of the present disclosure; and
FIG. 9 is a flow chart of a method for manufacturing a composite metal foil in an embodiment of the present disclosure.

### Reference Numerals:

100A, 100B, and 100C: device for manufacturing a composite metal foil;
10: first-time double-sided coating module; 20: second-time double-sided coating module; 30: steering module;
11: first vapor deposition column; 12: second vapor deposition column; 13: unwinding roller; 14: first evaporation source; 15: first set of over rollers; 15a: first over roller; 15b: second over roller; 16: second evaporation source; 17: second set of over rollers; 17a: third over roller; 17b: fourth over roller; 21: third vapor deposition column; 22: first set of cooling rollers; 22a: first cooling roller; 22b: second cooling roller; 23: third evaporation source; 24: second set of cooling rollers; 24a: third cooling roller; 24b: fourth cooling roller; 25: fourth evaporation source; 26: winding roller; 31: fourth vapor deposition column; 32: first steering roller; 33: second steering roller;
40: visual inspection system; 41: image acquisition apparatus; 42: image processing system; and 43: vapor deposition controller.

### DETAILED DESCRIPTION OF THE EMBODIMENTS

The features and exemplary embodiments of various aspects of the present disclosure are described in detail below. In the following detailed description, a number of specific details are provided to facilitate the comprehensive understanding of the present disclosure. However, it is obvious to those skilled in the art that the present disclosure may be implemented without some details among these specific details. The following description of embodiments is intended merely to make the present disclosure well understood by illustrating the examples of the present disclosure. In the accompanying drawings and the following description, at least part of the well-known structures and techniques are not shown to avoid unnecessary ambiguity to the present disclosure; and, for clarity, sizes of part of the structures may be exaggerated. In addition, the features, structures, or characteristics described below may be incorporated into one or more embodiments in any suitable manner.

### Embodiment 1

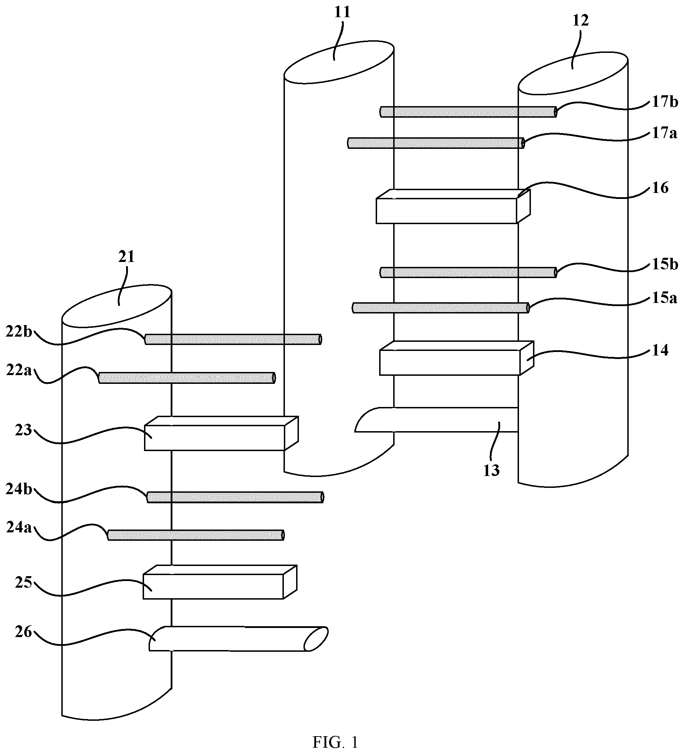

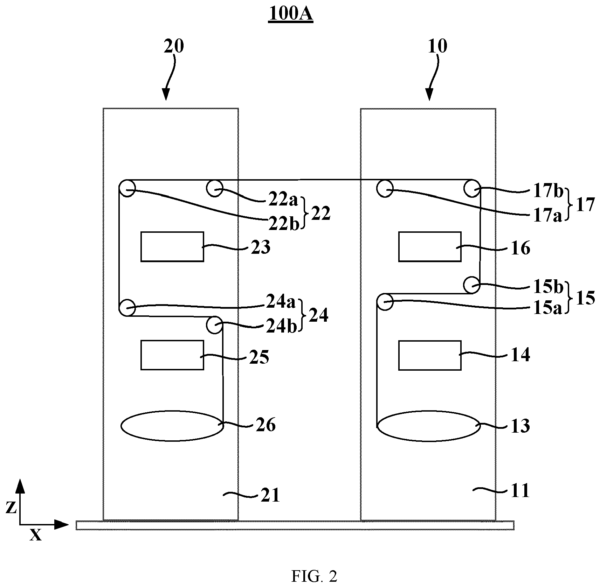

FIG. 1 is a 3D schematic view of a first device for manufacturing a composite metal foil in Embodiment 1 of the present disclosure; and FIG. 2 is a side schematic view of the first device for manufacturing a composite metal foil in Embodiment 1 of the present disclosure. As shown in FIG. 1 and FIG. 2, the device for manufacturing a composite metal foil includes: first-time double-sided coating module 10 and second-time double-sided coating module 20 that are arranged at an interval, where the first-time double-sided coating module 10 includes: first vapor deposition column 11 and second vapor deposition column 12 that are arranged oppositely, and unwinding roller 13, first evaporation source 14, first set of over rollers 15, second evaporation source 16, and second set of over rollers 17 that are arranged sequentially from bottom to top on opposite surfaces of the first vapor deposition column 11 and the second vapor deposition column 12; and the second-time double-sided coating module 20 includes: third vapor deposition column 21, and first set of cooling rollers 22, third evaporation source 23, second set of cooling rollers 24, fourth evaporation source 25, and winding roller 26 that are arranged sequentially from top to bottom on the third vapor deposition column 21. The composite metal foil can be obtained by depositing a metal such as copper or aluminum on a plastic film. The above technical solution has the following advantage: The sequential arrangement of the two evaporation sources and corresponding rollers from bottom to top on the opposite surfaces of the first vapor deposition column 11 and the second vapor deposition column 12 allows first-time double-sided coating, and the sequential arrangement of the two evaporation sources and corresponding rollers from top to bottom on the third vapor deposition column 21 allows second-time double-sided coating, which can improve the site utilization and the film production efficiency.

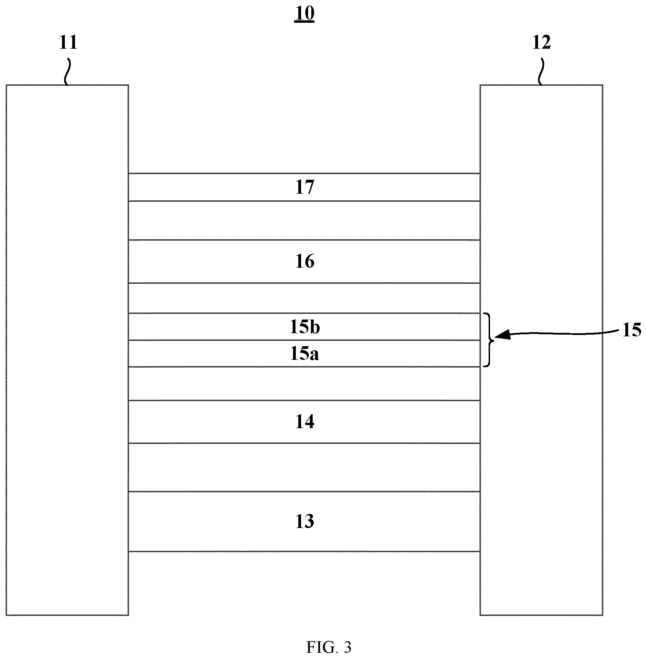

FIG. 3 is a front schematic view of first-time double-sided coating module 10 of the first device in Embodiment 1 of the present disclosure. As shown in FIG. 3, preferably, a first end of each of the unwinding roller 13, the first set of over rollers 15, and the second set of over rollers 17 is rotatably connected to the first vapor deposition column 11, and a second end of each of the unwinding roller 13, the first set of over rollers 15, and the second set of over rollers 17 is rotatably connected to the second vapor deposition column 12. One end of each of the first evaporation source 14 and the second evaporation source 16 is removably connected to the first vapor deposition column 11 or the second vapor deposition column 12, and the other end of each of the first evaporation source 14 and the second evaporation source 16 is suspended. Or, a first end of each of the first evaporation source 14 and the second evaporation source 16 is removably connected to the first vapor deposition column 11, and a second end of each of the first evaporation source 14 and the second evaporation source 16 is removably connected to the second vapor deposition column 12.

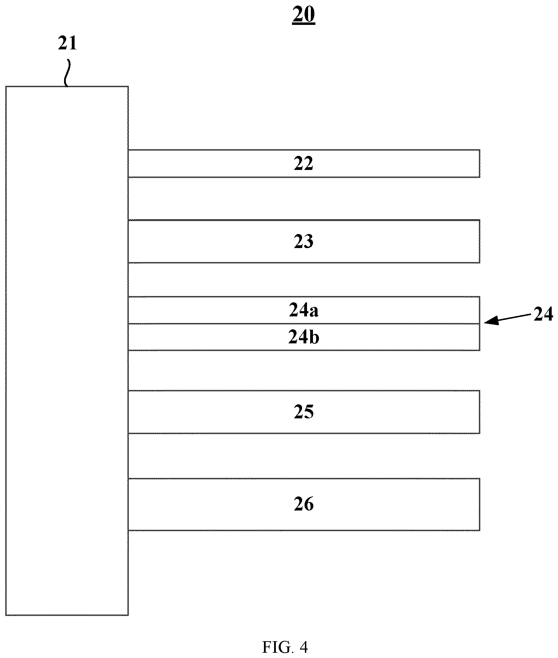

FIG. 4 is a front schematic view of second-time double-sided coating module 20 of the first device in Embodiment 1 of the present disclosure. As shown in FIG. 4, one end of each of the first set of cooling rollers 22, the second set of cooling rollers 24, and the winding roller 26 is rotatably connected to the third vapor deposition column 21, and the other end of each of the first set of cooling rollers 22, the second set of cooling rollers 24, and the winding roller 26 is suspended. One end of each of the third evaporation source 23 and the fourth evaporation source 25 is removably connected to the third vapor deposition column 21, and is not rotatable; and the other end of each of the third evaporation source 23 and the fourth evaporation source 25 is suspended. Alternatively, the third evaporation source 23 and the fourth evaporation source 25 may each be divided into two small-volume sub-evaporation sources (for example, the sub-evaporation sources have the same length as and a smaller width than the initial evaporation source) that are arranged side-by-side at an interval and have a same vertical arrangement height. Specifically, the first vapor deposition column 11, the second vapor deposition column 12, and the third vapor deposition column 21 are arranged vertically, and extend in a vertical direction (which is denoted as a direction Z); each roller and each evaporation source are arranged in a first horizontal direction (which is denoted as a direction Y); the first vapor deposition column 11 and the second vapor deposition column 21 are arranged at an interval in a second horizontal direction (which is denoted as a direction X); and X, Y, and Z are three coordinate axes of a space rectangular coordinate system. The vapor deposition column may have a platy structure, a cylindrical structure, and an elliptical structure. A shape of a horizontal cross section of the vapor deposition column in this embodiment is preferably elliptical. Compared with the platy structure, the elliptical structure leads to a small floor space; and compared with the cylindrical structure, the elliptical structure leads to a large surface area. A plurality of rollers and evaporation sources can be arranged on the surface, thereby reducing a floor space of the vapor deposition device and greatly improving the coating efficiency. In some embodiments, a material of the evaporation column may be a metal; the evaporation column may be hollow and have a cavity inside, such that some lines or the like can be accommodated in the evaporation column; and an inner wall of the evaporation column has a specified thickness, such that the inner wall can withstand a roller. A heating component is provided in the evaporation source, and the heating component can be an electric heating component, such as a heating wire or a hot liquid.

In some embodiments, the first set of over rollers 15 include first over roller 15a and second over roller 15b that are arranged at two upper sides of the first evaporation source 14, respectively, but a number of over rollers is not limited thereto, and the first set of over rollers 15 may include more than two over rollers; and the second set of over rollers 17 include third over roller 17a and fourth over roller 17b that are arranged at two upper sides of the second evaporation source 16, respectively, but a number of over rollers is not limited thereto, and the second set of over rollers 17 may include more than two over rollers. The arrangement of the third over roller 17a and the fourth over roller 17b at the two upper sides of the second evaporation source 16 is conducive to coating a surface B of a film. The first set of cooling rollers 22 include first cooling roller 22a and second cooling roller 22b, and the second set of cooling rollers 24 include third cooling roller 24a and fourth cooling roller 24b; a number of cooling rollers in each set of cooling rollers is not limited to 2 and can be greater than 2; the first set of cooling rollers 22, the third evaporation source 23, the second set of cooling rollers 24, the fourth evaporation source 25, and the winding roller 26 are arranged at a same side of the third vapor deposition column 21; the first evaporation source 14 is configured to apply a first coating to a first surface of a film to be coated; the second evaporation source 16 is configured to apply a first coating to a second surface of the film to be coated; the third evaporation source 23 is configured to apply a second coating to the second surface of the film to be coated; and the fourth evaporation source 25 is configured to apply a second coating to the first surface of the film to be coated.

In some embodiments, a vertical downward tangent line of the first over roller 15a at a left side coincides with a vertical downward tangent line of the unwinding roller 13 at a left side, and a vertical downward tangent line of the second over roller 15b at a right side coincides with a vertical downward tangent line of the unwinding roller 13 at a right side. Further, a vertical tangent line of the unwinding roller 13 at a left side is tangent to left sides of the first over roller 15a and the third over roller 17a, and a vertical tangent line of the unwinding roller 13 at a right side is tangent to right sides of the second over roller 15b and the fourth over roller 17b. In this embodiment, the first over roller 15a may be arranged at an upper left corner of the first evaporation source 14, and the second over roller 15b may be arranged at an upper right corner of the first evaporation source 14; and a vertical downward tangent line of the first over roller 15a at a left side coincides with a vertical downward tangent line of the unwinding roller 13 at a left side, and a vertical downward tangent line of the second over roller 15b at a right side coincides with a vertical downward tangent line of the unwinding roller 13 at a right side, such that a film does not wrinkle when delivered from the unwinding roller 13 to the first over roller 15a or the second over roller 15b.

In some embodiments, a plane in which a center line between the first over roller 15a and the second over roller 15b is located is a symmetrical plane between the first evaporation source 14 and the second evaporation source 16; or, a tangent plane of a top of the first over roller 15a or a tangent plane of a bottom of the second over roller 15b is a symmetrical plane between the first evaporation source 14 and the second evaporation source 16. The second evaporation source 16 is arranged above the first over roller 15a and the second over roller 15b in the same vertical direction as the first evaporation source 14, and a connecting line between central axes of the first over roller 15a and the second over roller 15b is set as a symmetrical line between the first evaporation source 14 and the second evaporation source 16 or a plane in which the central axes are located is set as a symmetrical plane between the two, such that the vapor deposition column is balanced under a force.

In some embodiments, a vertical arrangement height of the first over roller 15a is lower than a vertical arrangement height of the second over roller 15b, and the highest point of the top of the first over roller 15a is just on the same horizontal line as the lowest point of the bottom of the second over roller 15b, such that a film can travel from a top of the first over roller 15a to a bottom of the second over roller 15b and then be coated upwards, and the film can smoothly travel above the first evaporation source 14.

In some embodiments, at least one of the first over roller 15a, the second over roller 15b, the third over roller 17a, and the fourth over roller 17b is a cooling roller. In this way, a film can be cooled before and after vapor deposition, such that the film can be prevented from being burned through by high-temperature particles, which leads to formation of pores on the film and affects a quality of a product.

In some embodiments, the first set of over rollers 15, the second set of over rollers 17, the first set of cooling rollers 22, the second set of cooling rollers 24, the unwinding roller 13, and the winding roller 26 are parallel to each other.

A method for double-sided continuous coating with the device for manufacturing a composite metal foil in this embodiment includes the following steps:
S110: A film is placed on the unwinding roller 13, then released by the unwinding roller 13, and guided to pass through the first over roller 15a, an upper part of the first evaporation source 14, and the second over roller 15b, such that a first coating is applied to a surface A of the film.
S 120: The film is guided to pass through the fourth over roller 17b and an upper part of the second evaporation source 16 sequentially and reach the third over roller 17a, such that a first coating is applied to a surface B of the film.
S130: The film is guided to pass through the second cooling roller 22b and an upper part of the third evaporation source 23 sequentially and reach the first cooling roller 22a, such that a second coating is applied to the surface B of the film.
S140: The film is guided to pass through the third cooling roller 24a and an upper part of the fourth evaporation source 25 sequentially and reach the fourth cooling roller 24b, such that a second coating is applied to the surface A of the film.
S150: The film is guided to reach the winding roller 26 on the third vapor deposition column 21, such that double-sided continuous coating of the film is completed to obtain the composite metal foil.

### Embodiment 2

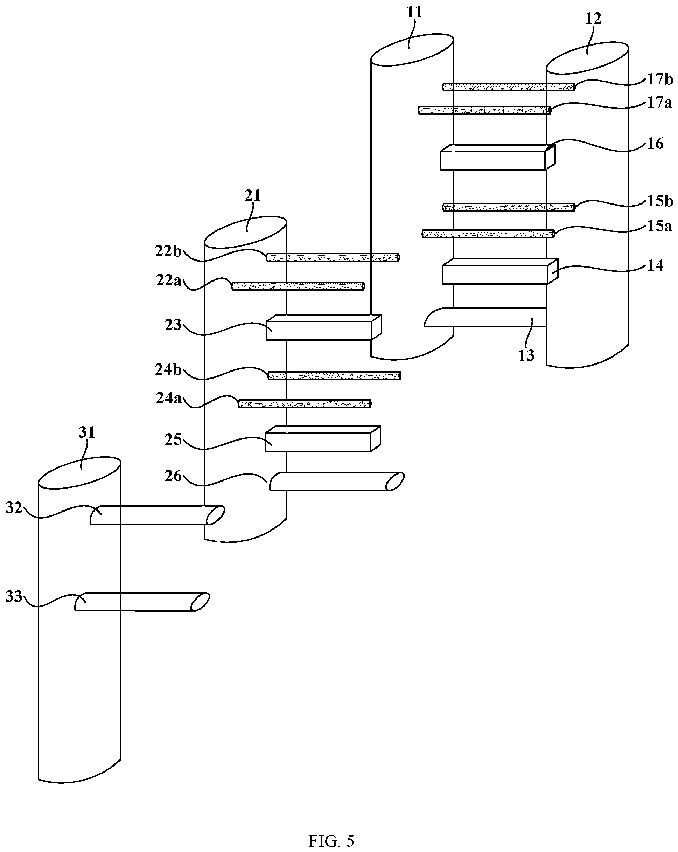

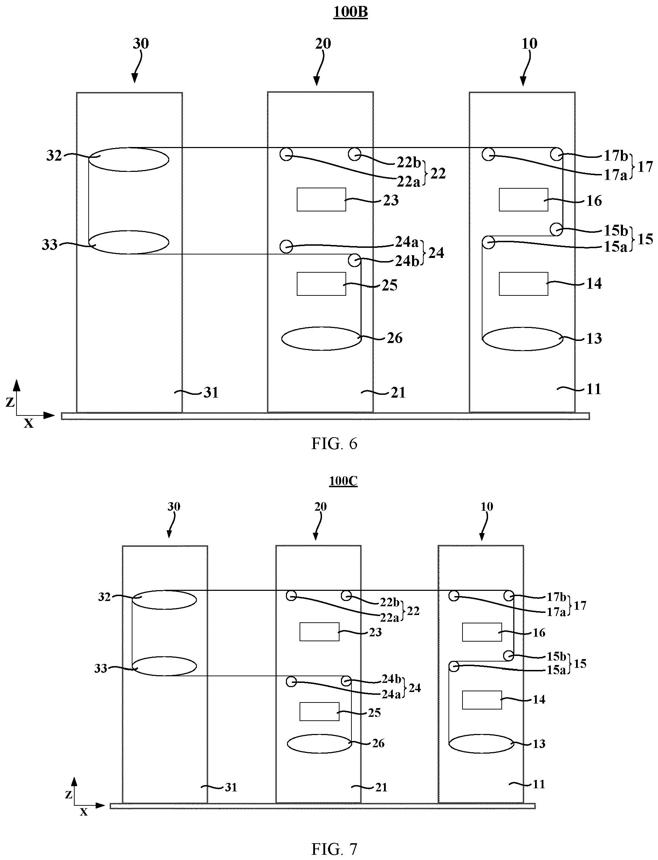

FIG. 5 is a 3D schematic view of a second device for manufacturing a composite metal foil in Embodiment 2 of the present disclosure; FIG. 6 is a side schematic view of the second device for manufacturing a composite metal foil in Embodiment 2 of the present disclosure; and FIG. 7 is a side schematic view of a third device for manufacturing a composite metal foil in Embodiment 2 of the present disclosure. As shown in FIG. 5 to FIG. 7, Embodiment 2 is different from Embodiment 1 in that, in order to coat two surfaces (A and B) of a film multiple times, the device for manufacturing a composite metal foil further includes: steering module 30, where the steering module includes fourth vapor deposition column 31, and first steering roller 32 and second steering roller 33 that are arranged at an interval sequentially from top to bottom on the fourth vapor deposition column 31; and the first vapor deposition column 11, the third vapor deposition column 21, and the fourth vapor deposition column 31 are arranged at an interval on a same straight line, for example, these components are arranged in a direction X. The arrangement of the two steering rollers in this embodiment has the following advantages: Since the first steering roller 32 and the first cooling roller 22a are parallel to each other and the second steering roller 33 and the third cooling roller 24a are parallel to each other, a film can be easily steered from a layer of the first steering roller 32 to a layer of the second steering roller 33. FIG. 5 is different from FIG. 4 in that the third cooling roller 24a and the fourth cooling roller 24b have a same vertical arrangement height in FIG. 5, while a vertical arrangement height of the third cooling roller 24a is higher than a vertical arrangement height of the fourth cooling roller 24b in FIG. 4.

One end of the unwinding roller 13 is rotatably connected to the first vapor deposition column 11, and the other end of the unwinding roller is rotatably connected to the second vapor deposition column 12; an evaporation source and an over roller are also provided above the unwinding roller 13; after a film is released from the unwinding roller 13 and passes through the over roller and the evaporation source, first-time double-sided coating is completed for the film; the third vapor deposition column 21 is provided with a cooling roller, an evaporation source, and a winding roller 26; the fourth vapor deposition column 31 is provided with two steering rollers; and after a film travels from the first vapor deposition column 11 and the second vapor deposition column 12, passes through the cooling roller and the evaporation source on the third vapor deposition column 21, and reaches the steering roller of the fourth vapor deposition column 31, double-sided continuous coating is completed for the film to obtain a composite metal foil.

In some embodiments, the device for manufacturing a composite metal foil further includes one or more of the following: a visual inspection system, a rotational speed-controlling apparatus, an evaporation rate-controlling apparatus, and a vacuum cavity.

The visual inspection system is arranged on the first vapor deposition column 11, the second vapor deposition column 12, the third vapor deposition column 21, or the fourth vapor deposition column 31 and configured to detect a pore defect on a film to be coated; and when it is detected that there is a pore defect on the film, a signal to stop coating is output. Specifically, the visual inspection system can be a CDD vision inspection system, which can automatically identify a pore on a film to determine whether to continue coating.

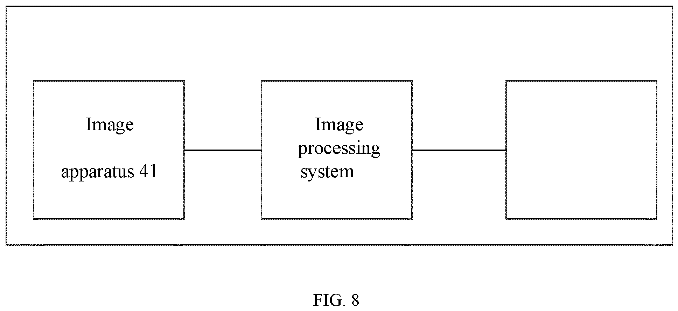

FIG. 8 is a functional block diagram of the visual inspection system in this embodiment of the present disclosure. As shown in FIG. 8, the visual inspection system 40 may include: image acquisition apparatus 41 configured to shoot an image of a surface of a film in vapor deposition; image processing system 42 configured to acquire the image of the surface of the film in vapor deposition and perform a pore defect detection based on the image of the surface of the film in vapor deposition (which can be based on an image recognition algorithm) to determine pore defect data for the surface of the film in vapor deposition; and vapor deposition controller 43 configured to determine whether a control signal to stop vapor deposition is output or an alarm signal is output according to the pore defect data for the surface of the film in vapor deposition and preset conditions (for example, one or more preset threshold conditions are met). The pore data includes at least one of the following: a number of pores distributed per unit area, a size of pores per unit area, and a distribution density of pores per unit area. The size may be a maximum size of the pores or a diameter of an equivalent circle of the pores, where an area of the irregular pores can be calculated and then converted into the diameter of the equivalent circle. Accordingly, the preset conditions include at least one of the following: a number of pores distributed per unit area is greater than a preset number threshold, a size of pores per unit area is greater than a preset diameter threshold, and a distribution density of pores per unit area is greater than a preset density threshold. The outputting a control signal to stop vapor deposition may include: outputting a control signal to stop rotation to a drive motor of each roller, or cutting off a working power supply of a drive motor, or cutting off working power supplies of all evaporation sources. The visual inspection system may be arranged entirely inside the vacuum cavity, for example, the visual inspection system may be arranged on an inner wall of the vacuum cavity or on an associated vapor deposition column; or at least the image acquisition apparatus is arranged inside the vacuum cavity, and other components are arranged outside the vacuum cavity.

Specifically, the image acquisition apparatus 41 adopts a high-brightness light-emitting diode (LED) industrial linear light-gathering light source with a specific wavelength to illuminate a surface of a product (a reflection detection principle is adopted for an opaque film product), and adopts an industrial charge-coupled device (CCD) camera to scan and acquire an image of a product irradiated by the light source in real time.

Specifically, a specific working principle of the CCD visual inspection system is as follows: when a film passes through an inside of the CCD, the image acquisition apparatus 41 arranged at an upper part inside the CCD converts acquired conditions on a surface of the film into an image signal and transmits the image signal to the image processing system 42; the image processing system 42 automatically calculates a number and size of pores on the surface of the film according to a set program; and when a number and/or size of pores per square centimeter exceeds a preset specific threshold value, the vapor deposition controller 43 issues a command to the rotational speed-controlling apparatus to stop vapor deposition, or sounds an alarm to make an operator stop vapor deposition. The one or more thresholds vary according to quality requirements of a customer, for example, a number of pores per square meter may not exceed a few to dozens, and a size of pores does not exceed a few tenths of a millimeter or a few millimeters.

The rotational speed-controlling apparatus includes a control panel and a servo motor, where the control panel is in communication connection with the servo motor; the control panel is configured to receive rotational-speed-controlling parameters input by a user and transmit the rotational-speed-controlling parameters to the servo motor; and the servo motor is configured to control a rotational speed of any one or more of the unwinding roller 13, the first set of over rollers 15, the second set of over rollers 17, the first set of cooling rollers 22, the second set of cooling rollers 24, and the winding roller 26 according to the rotational-speed-controlling parameters. Specifically, a rotational speed of a roller can be controlled by the servo motor. For example, a control panel is provided, and parameters can be input in the control panel to control a rotational speed of a roller.

The evaporation rate-controlling apparatus is electrically connected to the first evaporation source 14, the second evaporation source 16, the third evaporation source 23, and the fourth evaporation source 25 and is configured to control a working current applied to each of the first evaporation source 14, the second evaporation source 16, the third evaporation source 23, and the fourth evaporation source 25 to control respective heat generation, thereby controlling an evaporation rate. Specifically, a current applied to a heating wire can be controlled to control heat generation of the heating wire, thereby controlling an evaporation rate of an evaporation source.

First-time double-sided coating module 10 and second-time double-sided coating module 20 are arranged inside the vacuum cavity. When in a working state, the vacuum cavity is preferably in a vacuum state inside.

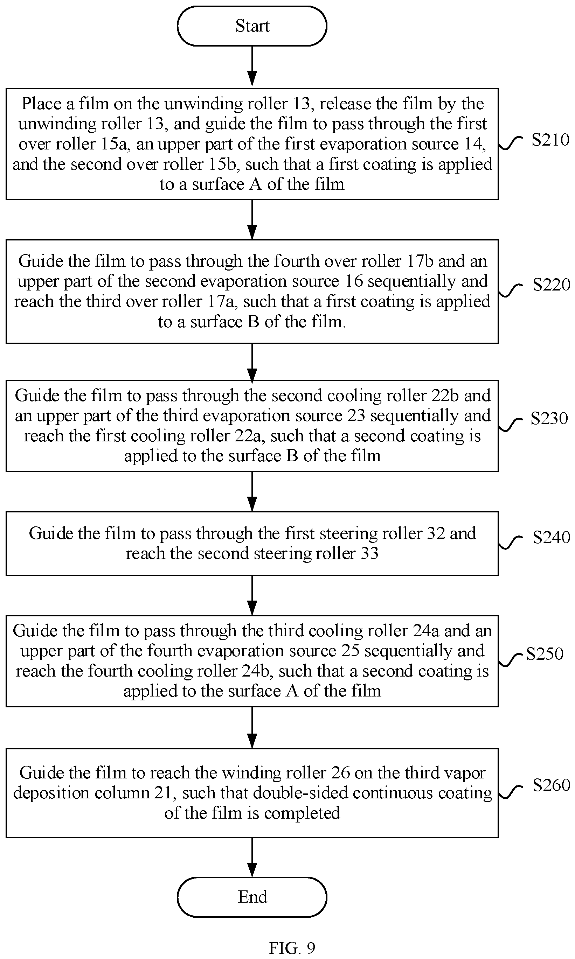

FIG. 9 is a flow chart of a method for manufacturing a composite metal foil in this embodiment of the present disclosure. As shown in FIG. 9, a method for manufacturing the composite metal foil in this embodiment includes the following steps:
S210: A film is placed on the unwinding roller 13, then released by the unwinding roller 13, and guided to pass through the first over roller 15a, an upper part of the first evaporation source 14, and the second over roller 15b, such that a first coating is applied to a surface A of the film.
S220: The film is guided to pass through the fourth over roller 17b and an upper part of the second evaporation source 16 sequentially and reach the third over roller 17a, such that a first coating is applied to a surface B of the film.
S230: The film is guided to pass through the second cooling roller 22b and an upper part of the third evaporation source 23 sequentially and reach the first cooling roller 22a, such that a second coating is applied to the surface B of the film.
S240: The film is guided to pass through the first steering roller 32 and reach the second steering roller 33.
S250: The film is guided to pass through the third cooling roller 24a and an upper part of the fourth evaporation source 25 sequentially and reach the fourth cooling roller 24b, such that a second coating is applied to the surface A of the film.
S260: The film is guided to reach the winding roller 26 on the third vapor deposition column 21, such that double-sided continuous coating of the film is completed to obtain the composite metal foil.

It should be noted that, in the description of the present disclosure, orientations or position relationships indicated by terms such as "upper", "lower", "inner", and "outer" are orientation or position relationships shown in the accompanying drawings. These terms are merely used to facilitate and simplify the description, rather than to indicate or imply that the mentioned apparatus or elements must have a specific orientation and must be established and operated in a specific orientation. Therefore, these terms should not be understood as a limitation to the present disclosure. Moreover, the term "first", "second", or "third" is merely used for description, and is not intended to indicate or imply relative importance.

Unless otherwise clearly specified and defined, the terms such as "arranged", "connected with", and "connected to" in the present disclosure should be understood in a broad sense. For example, the "connection" may be a fixed connection or a detachable connection or an integral connection; may be a mechanical connection, an electrical connection, or a direct connection; and may be an indirect connection through an intermediate medium or intercommunication between two components. A person of ordinary skill in the art may understand specific meanings of the above terms in the present disclosure based on a specific situation.

Although the present disclosure has been described with reference to the preferred embodiments, various improvements can be made and components therein can be replaced with equivalents without departing from the scope of the present disclosure. In particular, as long as there is no structural conflict, the technical features in the embodiments may be combined in any way. The present disclosure is not limited to the specific embodiments disclosed herein, but should include all technical solutions falling within the scope of the claims.

## Claims

1. A device for manufacturing a composite metal foil, comprising: a first-time double-sided coating module and a second-time double-sided coating module that are arranged at an interval,
wherein the first-time double-sided coating module comprises: a first vapor deposition column and a second vapor deposition column that are arranged oppositely, and an unwinding roller, a first evaporation source, a first set of over rollers, a second evaporation source, and a second set of over rollers that are arranged sequentially from bottom to top on opposite surfaces of the first vapor deposition column and the second vapor deposition column; and
the second-time double-sided coating module comprises: a third vapor deposition column, and a first set of cooling rollers, a third evaporation source, a second set of cooling rollers, a fourth evaporation source, and a winding roller that are arranged sequentially from top to bottom on the third vapor deposition column.

2. The device for manufacturing the composite metal foil according to claim 1, wherein the first set of over rollers comprise a first over roller and a second over roller that are arranged at two upper sides of the first evaporation source, respectively; the second set of over rollers comprise a third over roller and a fourth over roller that are arranged at two upper sides of the second evaporation source, respectively;
the first evaporation source is configured to apply a first coating to a first surface of a film to be coated; the second evaporation source is configured to apply a first coating to a second surface of the film to be coated; the third evaporation source is configured to apply a second coating to the second surface of the film to be coated; and the fourth evaporation source is configured to apply a second coating to the first surface of the film to be coated.

3. The device for manufacturing the composite metal foil according to claim 2, wherein a vertical downward tangent line of the first over roller at a left side coincides with a vertical downward tangent line of the unwinding roller at a left side, and a vertical downward tangent line of the second over roller at a right side coincides with a vertical downward tangent line of the unwinding roller at a right side.

4. The device for manufacturing the composite metal foil according to claim 2, wherein a plane in which a center line between the first over roller and the second over roller is located is a symmetrical plane between the first evaporation source and the second evaporation source; or, a tangent plane of a top of the first over roller or a tangent plane of a bottom of the second over roller is a symmetrical plane between the first evaporation source and the second evaporation source.

5. The device for manufacturing the composite metal foil according to claim 2, wherein the first set of cooling rollers comprise a first cooling roller and a second cooling roller, and the second set of cooling rollers comprise a third cooling roller and a fourth cooling roller; and the first set of cooling rollers, the third evaporation source, the second set of cooling rollers, the fourth evaporation source, and the winding roller are arranged at a same side of the third vapor deposition column.

6. The device for manufacturing the composite metal foil according to claim 2, wherein the first set of over rollers, the second set of over rollers, the first set of cooling rollers, the second set of cooling rollers, the unwinding roller, and the winding roller are parallel to each other; the first vapor deposition column, the second vapor deposition column, and the third vapor deposition column are arranged in a vertical direction; and a vertical arrangement height of the first over roller is lower than a vertical arrangement height of the second over roller, and the highest point of the top of the first over roller is on the same horizontal line as the lowest point of the bottom of the second over roller.

7. The device for manufacturing the composite metal foil according to claim 2, further comprising: a steering module, wherein the steering module comprises a fourth vapor deposition column, and a first steering roller and a second steering roller that are arranged sequentially from top to bottom on the fourth vapor deposition column; and the first vapor deposition column, the third vapor deposition column, and the fourth vapor deposition column are arranged at an interval on a same straight line.

8. A system for manufacturing a composite metal foil, comprising:
the device for manufacturing the composite metal foil according to any one of claims 1 to 7;
a visual inspection system, wherein the visual inspection system is arranged on the first vapor deposition column, the second vapor deposition column, the third vapor deposition column, or the fourth vapor deposition column or on an inner wall of a vacuum cavity, and configured to detect a pore defect on a film to be coated; and when acquired pore defect data meets preset conditions, a signal to stop coating is output; and
the vacuum cavity, wherein the device for manufacturing the composite metal foil according to any one of claims 1 to 7 is arranged inside the vacuum cavity.

9. The system for manufacturing the composite metal foil according to claim 8, wherein the visual inspection system comprises:
an image acquisition apparatus configured to shoot an image of a surface of a film in vapor deposition;
an image processing system configured to acquire the image of the surface of the film in vapor deposition and perform a pore defect detection based on the image of the surface of the film in vapor deposition to determine pore defect data for the surface of the film in vapor deposition; and
a vapor deposition controller configured to determine whether a control signal to stop vapor deposition is output or an alarm signal is output according to the pore defect data and preset conditions.

10. A method for manufacturing a composite metal foil based on the device for manufacturing the composite metal foil according to claim 5, comprising the following steps:
releasing a film by the unwinding roller, and guiding the film to pass through the first over roller, an upper part of the first evaporation source, and the second over roller, such that a first coating is applied to a surface A of the film;
guiding the film to pass through the fourth over roller and an upper part of the second evaporation source sequentially and reach the third over roller, such that a first coating is applied to a surface B of the film;
guiding the film to pass through the second cooling roller and an upper part of the third evaporation source sequentially and reach the first cooling roller, such that a second coating is applied to the surface B of the film;
guiding the film to pass through the first steering roller and reach the second steering roller;
guiding the film to pass through the third cooling roller and an upper part of the fourth evaporation source sequentially and reach the fourth cooling roller, such that a second coating is applied to the surface A of the film; and
guiding the film to reach the winding roller, such that double-sided continuous coating of the film is completed to obtain the composite metal foil.
